# EUROPÄISCHE PATENTANMELDUNG

(11) **EP 0 634 504 A1**
(43) Veröffentlichungstag der Anmeldung: **18.01.1995**
(21) Anmeldenummer: 94110962.1
(22) Anmeldetag: 14.07.1994
(51) Int. Cl.: C30B 15/08

(54) **Verfahren zur Herstellung von Stäben oder Blöcken aus beim Erstarren sich ausdehnendem Halbleitermaterial durch Kristallisieren einer aus Granulat erzeugten Schmelze**

(30) Priorität: 15.07.1993 DE 4323793
(71) Anmelder: Wacker-Siltronic Gesellschaft für Halbleitermaterialien mbH, D-84489 Burghausen (DE)
(72) Erfinder: Geissler, Joachim, D-84533 Stammham (DE); Angres, Ulrich, D-84533 Marktl (DE)
(74) Vertreter: Rimböck, Karl-Heinz, Dr.

(57) **Zusammenfassung**

Bei dem Verfahren wird eine eine feste Phase des Halbleitermaterials überschichtende geschmolzene Phase des Materials mit einer dieser festen Phase gegenüberliegenden freien Oberfläche erzeugt, in welche beim Kristallisationsvorgang Energie eingestrahlt und Material in Granulatform zugeführt wird, welches aufschwimmt und aufgeschmolzen wird. Dadurch kommt es auf der gegenüberliegenden Grenzfläche fest/flüssig zum Aufwachsen von Material auf die feste Phase, welche nach Maßgabe der Aufwachsgeschwindigkeit nach unten abgezogen wird. Mit dem Verfahren lassen sich mono- oder multikristalline Stäbe oder Blöcke erhalten. Hauptvorteile des Prozesses liegen darin, daß ohne Schmelzgefäße gearbeitet werden kann, der Einsatz von Granulat möglich ist und die Energiebilanz wegen der geringen Schmelzenmengen günstig ist.

## Beschreibung

Verfahren zur Herstellung von Stäben oder Blöcken aus beim Erstarren sich ausdehnendem Halbleitermaterial durch Kristallisieren einer aus Granulat erzeugten Schmelze sowie Vorrichtung zu seiner Durchführung.

Die Erfindung betrifft ein Verfahren zur Herstellung von Stäben oder Blöcken aus beim Erstarren sich ausdehnendem Halbleitermaterial durch Kristallisieren einer aus Granulat erzeugten Schmelze, sowie Vorrichtungen zu seiner Durchführung.

Mono- oder polykristalline Stäbe oder Blöcke aus Silicium werden gewöhnlich durch Tiegelziehen nach Czochralski, durch tiegelloses Zonenziehen oder durch Gießprozesse hergestellt, bei denen eine Siliciumschmelze in Kokillen aus Quarz oder Graphit eingegossen und dort einer gerichteten Erstarrung unterworfen wird. Für das Zonenziehen sind dabei durch schonende Gasphasenabscheidung unter sorgfältig kontrollierten Bedingungen hergestellte polykristalline Vorratsstäbe erforderlich. Beim Tiegelziehen oder Gießprozessen kann als Ausgangsmaterial zwar mit demgegenüber geringerem Aufwand abgeschiedenes stückiges polykristallines Silicium eingesetzt werden, jedoch sind die verwendeten Tiegel oder Kokillen sowohl mögliche Ursache von Verunreinigungen als auch von zusätzlichen Kosten. Ahnliche Probleme treten wegen der langen Kontaktzeit von geschmolzenem Silicium mit Gefäßwänden aus Fremdmaterial auch bei dem Verfahren gemäß der DE-A-29 25 679 bzw. der entsprechenden US-A-4,312,700 auf, bei dem eine in einem separaten Schmelztiegel erzeugte Siliciumschmelze in eine Kristallisationskammer geleitet wird, in welcher ein Schmelzsee aufrechterhalten wird, aus dem das kristallisierende Material nach unten abgezogen wird. Gleiches gilt für das Verfahren gemäß der DE-A-35 31 610, bei dem der Schmelzsee von aus gegenüber Silicium inertem Material gefertigten Rollen umschlossen ist, wobei das geschmolzene Silicium in dessen freie Oberfläche eingegossen wird, während das erstarrende Material analog dem vorgenannten Verfahren nach unten abgezogen wird. Während die erwähnten Gießverfahren im wesentlichen für die Herstellung von Solarzellengrundmaterial eingesetzt werden, werden die durch Tiegel- oder Zonenziehen erhaltenen Stäbe üblicherweise in Scheiben zersägt, aus denen dann in den meisten Fällen elektronische oder Leistungsbauelemente gefertigt werden. Die Anwendungsbereiche der einzelnen Verfahren sind dabei beschränkt; so läßt sich z.B. mit Gieß-oder Tiegelziehprozessen kein Material herstellen, das beispielsweise von der Art und dem Anteil der Verunreinigungen her zonengezogenem Material entspricht. Darüber hinaus ist die Energiebilanz mancher Verfahren ungünstig: während einerseits mit großem Energieaufwand eine verhältnismäßig große Schmelzenmenge bereitgestellt werden muß, muß nach der Kristallisation eine ebenso erhebliche Energiemenge durch Kühlung wieder abgeführt werden.

Aufgabe der Erfindung war es daher, ein Verfahren anzugeben, das vielseitig anwendbar ist und mit einer günstigen Energiebilanz bei Halbleitermaterialien wie Germanium oder insbesondere Silicium sowohl die Herstellung einkristalliner Stäbe als auch multikristalliner Blöcke gestattet, das höchsten Reinheitsansprüchen gerecht wird und, insbesondere bei der Einkristallherstellung, den Einsatz von Material in Granulatform ermöglicht, ohne auf die Verwendung von Schmelztiegeln angewiesen zu sein.

Gelöst wird die Aufgabe durch ein Verfahren, welches dadurch gekennzeichnet ist, daß eine eine feste Phase des Halbleitermaterials überschichtende geschmolzene Phase des Materials mit einer dieser festen Phase gegenüberliegenden freien Oberfläche erzeugt wird, und daß beim Kristallisationsvorgang zur Aufrechterhaltung der geschmolzenen Phase in die freie Oberfläche der Schmelze Energie zugeführt und kontinuierlich oder taktweise Granulat chargiert wird wodurch an der gegenüberliegenden Schmelzenoberfläche das Material zum Aufwachsen auf die feste Halbleiterphase gebracht wird.

Die zur Erzeugung und Aufrechterhaltung der geschmolzenen Phase des Halbleitermaterials, insbesondere Silicium erforderliche Energie wird zweckmäßig in Form von Strahlungsenergie zugeführt. Mit besonderem Vorteil wird dafür Elektronenstrahlung eingesetzt, da diese Art der Energiezufuhr den in der Halbleitertechnik üblichen Reinheitsanforderungen problemlos erfüllen lassen und gleichzeitig der Einwirkungsbereich und die eingestrahlte Energiemenge leicht zu steuern und zu variieren sind. Dabei können eine oder mehrere Strahlungsquellen zur Einwirkung auf den aufzuschmelzenden oder schmelzflüssig zu haltenden Bereich kommen, um eine ausreichende Energieversorgung der gesamten freien Oberfläche der geschmolzenen Siliciumphase sicherzustellen. In vielen Fällen hat es sich auch als günstig erwiesen, die zu bestrahlende Fläche mit einem oder mehreren Elektronenstrahlen abzurastern, die dabei jeweils auf einen demgegenüber kleineren Flächenausschnitt einwirken. Grundsätzlich ist auch der Einsatz von anderer elektromagnetischer Strahlung wie etwa Lichtstrahlung denkbar, die beispielsweise mittels Laserquellen oder energiereichen Lichtquellen wie Quecksilberdampflampen auf die zu bestrahlende Fläche gerichtet wird, wobei ggf. durch Abrasterung oder Fokussierung mittels geeigneter Reflektoren eine gleichmäßige Bestrahlung der Fläche sichergestellt werden kann. Eine andere Ausführungsform sieht vor, die Energie zur Aufrechterhaltung der geschmolzenen Phase mit Hilfe einer Induktionsheizspule zuzuführen. Geeignete Induktionsheizspulen sind beispielsweise von der Herstellung zonengezogener Kristalle bekannt.

Das Verfahren eignet sich im Grunde für die Kristallisation von allen Halbleitermaterialien, die das Phänomen der Volumenexpansion beim Erstarren zeigen, die also im festen Zustand eine geringere Dichte als im schmelzflüssigen Zustand besitzen. Im wesentlichen sind dies die Elementhalbleiter Germanium und insbesondere Silicium als das derzeit in der Elektronik und Solarzellentechnologie wichtigste Halbleitermaterial, bei dem die Volumenvergrößerung beim Erstarren etwa 10% beträgt. Aus Gründen der Vereinfachung werden die folgenden Ausführungen nur auf Silicium bezogen, sie lassen sich jedoch sinngemäß auch auf Germanium oder andere beim Erstarren sich ausdehnende Materialien, insbesondere Halbleitermaterialien übertragen.

Das Verfahren wird dadurch eingeleitet, daß in einem ersten Schritt eine geschmolzene Siliciumphase erzeugt wird, die eine feste Siliciumphase überschichtet und eine dieser Grenzfläche zur festen Phase gegenüberliegende freie Oberfläche besitzt. Dies kann beispielsweise dadurch geschehen, daß ein den vorgesehenen Querschnitt und die vorgesehene Kristallstruktur besitzender, z.B. runder, rechteckiger oder quadratischer mono- oder multikristalliner Siliciumkristall - der damit gleichzeitig als Impfkristall wirken kann - von seiner Stirnseite her aufgeschmolzen wird, bis ein Schmelzsee der vorgesehenen Höhe entstanden ist, der den nicht aufgeschmolzenen Restkristall überlagert. Der Außenumfang des Schmelzsees kann dabei gegebenenfalls durch stützende oder formgebende Elemente stabilisiert sein. Eine andere Möglichkeit besteht darin, daß ein beispielsweise scheiben- oder plattenförmiges Flächengebilde aus Silicium vorgesehen wird, welches nach und nach in der Weise angeschmolzen wird, daß eine seitlich von einem Ring aus nicht aufgeschmolzenem festem Silicium umgebene Schmelzlinse entsteht. Der Durchmesser dieses linsenförmigen Schmelzsees kann durch Variation der bestrahlten Fläche beeinflußt, z.B. verengt oder erweitert werden und bestimmt letztlich den Querschnitt des daraus erhaltenen Kristalls. Die der freien, die eingestrahlte Energie aufnehmenden Oberfläche gegenüberliegende Oberfläche der Schmelzlinse eignet sich beispielsweise zum Ansetzen von Impfkristallen oder Stützkristallen, durch welche sie stabilisiert und die Kristallisation eingeleitet werden kann. Eine weitere Möglichkeit zur Erzeugung des Schmelzsees liegt darin, einen gegebenenfalls mit einer geeigneten Vertiefung oder Ausnehmung versehenen, beispielsweise platten-, scheiben- oder blockförmigen Basiskristall auf seiner der Strahlungsquelle zugewandten Fläche mit Granulat zu beschichten und dieses aufzuschmelzen, wobei zusätzlich auch eine den entstehenden Schmelzsee seitlich umgebende Fassung, zweckmäßig aus massivem Silicium, vorgesehen sein kann. Das Granulat kann auch nicht vollständig aufgeschmolzen werden; es ist dann möglich, zwischen Basiskristall und eigentlichem Schmelzsee eine gesinterte Granulatzwischenschicht zu erzeugen, insbesondere wenn kein monokristallines Produkt hergestellt werden soll. In diesem Fall kann auch die Zwischenschicht direkt auf die, zweckmäßig kühlbare und beispielsweise aus Metall oder keramischem Material bestehende, Unterlage aufgebracht werden, ohne daß ein Basiskristall aus Silicium vorgesehen ist.

Bei dem Verfahren wird das zu chargierende Granulat zweckmäßig in Korngrößen von 0.1 bis 10 mm, bevorzugt 1 bis 6 mm eingesetzt, wobei diese Angaben so zu verstehen sind, daß jeweils Siebe mit einer der gewählten Untergrenze entsprechenden Maschenweite nicht mehr, mit einer der gewählten Obergrenze entsprechenden Maschenweite vollständig passiert werden. Bei Granulat mit geringerer Korngröße besteht erfahrungsgemäß die Gefahr des Verwirbelns im Rezipienten, während größere Körner unter Umständen eine zu große Eintauchtiefe im Schmelzsee aufweisen und die Kristallisationsfront stören können. Die geeigneten Körnungsfraktionen lassen sich durch übliche Klassierverfahren, beispielsweise mittels Sieben, aus den bekannten zur Verfügung stehenden Siliciumgranulaten mit ihren demgegenüber weiteren Korngrößenbereichen abtrennen. Dabei kann z.B. mittels eines Siebes mit 0.1 mm Maschenweite die Feinkornfraktion, und mittels eines Siebes mit 10 mm Maschenweite die Grobkornfraktion abgetrennt werden, so daß letztlich eine innerhalb dieser Unter- und Obergrenze variierende Granulatfraktion verbleibt. Insbesondere beim Züchten von Einkristallen oder bei weitgehend automatisierten Prozessen wird man jedoch demgegenüber engere Grenzen, vorteilhaft zwischen 1 und 6 mm, auswählen, da dann ein gleichmäßigeres Aufschmelzverhalten des chargierten Granulates zu erwarten ist. Grobkörnige Granulate haben auch den Vorteil, daß sie wegen der kleineren Oberfläche über die die Körner umgebende Oxidhaut weniger Sauerstoff in das System einbringen. Das Granulat kann beispielsweise durch mechanische Zerkleinerung von auf erhitzten Trägerkörpern abgeschiedenem polykristallinem Silicium hergestellt sein. Gleichfalls geeignet ist Material in Granulatform, welches durch einen Wirbelschichtabscheidungsprozeß hergestellt ist und typisch annähernd Kugelform aufweist.

Die erste Stufe des Verfahrens ist dann abgeschlossen, wenn der Schmelzsee die gewünschte Ausdehnung und Tiefe erreicht hat und die Phasengrenze zwischen der schmelzflüssigen und der festen Phase sich in ihrer Lage stabilisiert hat. Zur Aufrechterhaltung dieses im Idealfall einem thermodynamischen Gleichgewicht zwischen Schmelze und Kristall entsprechenden Zustandes ist es dann ausreichend, der Schmelze über die freie Schmelzoberfläche in dem Maße Energie zuzuführen, wie andererseits von ihr beispielsweise durch Strahlungsverluste und dergl. Energie abgegeben wird. In der Praxis herrscht innerhalb der Schmelze daher ein Temperaturgefälle zwischen der heißeren, die eingestrahlte Energie aufnehmenden freien Oberfläche und der kühleren gegenüberliegenden Phasengrenzfläche fest/schmelzflüssig, an der die Temperatur der Schmelztemperatur des Siliciums entspricht. Wird der Gleichgewichtszustand gestört, indem über die freie Oberfläche zusätzlich der schmelzflüssigen Phase Granulat zugeführt wird, welches wegen seiner geringeren Dichte aufschwimmend an der Oberfläche verbleibt, so bewirkt dies zunächst eine Veränderung der Temperaturverhältnisse in der Schmelze, als deren Folge an der gegenüberliegenden Phasengrenze zur festen Phase Material aus der Schmelze auszukristallisieren beginnt: die feste Phase schiebt sich vor, und der von der schmelzflüssigen Phase überschichtete Kristall wächst. In dem Maße, in dem das Granulat in den geschmolzenen Zustand übergeht, schreitet an der gegenüberliegenden Phasengrenze der Kristallisationsvorgang voran. Das Wachstum endet, wenn alles Granulat aufgeschmolzen und erneut ein Gleichgewichtszustand zwischen schmelzflüssiger und überschichteter fester Phase erreicht ist.

Der eigentliche Kristallherstellungsprozeß kann daher in der Weise eingeleitet und fortgesetzt werden, daß in die freie Oberfläche der in der ersten Verfahrensstufe erzeugten geschmolzenen Phase Siliciumgranulat chargiert wird. Diese Granulatzufuhr kann kontinuierlich oder taktweise erfolgen, wobei aus Gründen der gleichmäßigeren Kristallisationsgeschwindigkeit und der daraus sich ergebenden konstanten Zieh- bzw. Absenkgeschwindigkeit die kontinuierliche Zugabe bevorzugt wird. Das Granulat kann dabei mit Hilfe der bekannten Zufuhr- und Dosiereinrichtungen wie etwa Schüttelrinnen oder Schwing- bzw. Rotationsförderern zuchargiert werden. Die jeweils einzuhaltende Zufuhrrate wird zweckmäßig rechnerisch abgeschätzt und/oder in Vorversuchen ermittelt, wobei neben der Größe der zu beschickenden freien Oberfläche hauptsächlich die in der Schmelze vorhandene Energiemenge wie auch die möglichen Aufwachs- bzw. Kristallisationsgeschwindigkeiten im der freien Oberfläche gegenüberliegenden Übergangsbereich zur festen Siliciumphase zu berücksichtigen sind. Wenn die geschmolzene Phase mit Hilfe einer Induktionsheizspule aufrechterhalten wird, wird das Granulat vorzugsweise durch die ringförmige Öffnung der Induktionsheizspule oder durch den Zwischenraum zwischen Induktionsheizspule und der Oberfläche der geschmolzenen Phase zuchargiert.

Um eine genügende Höhe und eine ausreichende Wärmekapazität der Siliciumschmelze zu gewährleisten, wird zweckmäßig die Temperatur der Schmelze im Bereich der freien Oberfläche auf Werten gehalten, die um bis zu etwa 200°C, vorzugsweise 50 bis 150°C über der Schmelztemperatur des Siliciums (ca. 1420°C) liegen. Diese überhitzung der freien Schmelzenoberfläche gewährleistet gleichzeitig, daß die nachchargierten Granulatkörner mit der gewünschten Geschwindigkeit aufgeschmolzen werden. Dadurch kann sichergestellt werden, daß der Energieinhalt der geschmolzenen Phase ausreicht, um größere Schmelzgeschwindigkeiten zu erreichen als andererseits Kristallisationsgeschwindigkeiten für das Wachstum von defektarmen oder defektfreien Stäben oder Blöcken noch zulässig sind. Dies kann beispielsweise dadurch unterstützt werden, daß die Prozeßparameter so aufeinander abgestimmt werden, daß das Volumen der Schmelze deutlich größer gehalten wird als das Volumen der jeweils im ungeschmolzenen Zustand in der Schmelze schwimmenden nachchargierten Granulatkörner. Gegebenenfalls kann das Granulat auch in vorgeheiztem Zustand eingesetzt werden.

Die Schmelzentemperatur an der freien Oberfläche kann mit Hilfe der auch vom Tiegel- oder Zonenziehen her bekannten Temperaturmeßgeräte überwacht werden. Als Beispiel für solche geeigneten Geräte seien Pyrometer genannt.

Mit der Zugabe von Granulat in die freie Oberfläche der geschmolzenen Phase und dessen allmählichem Aufschmelzen setzt an der gegenüberliegenden Phasengrenze flüssig/fest das Wachstum der festen Phase ein, wodurch sich diese entsprechend der Aufwachsgeschwindigkeit in Richtung Schmelze vorschiebt. Grundsätzlich besteht nun die Möglichkeit, den gegebenenfalls gedrehten Stab oder Block in einer ortsfesten Position zu belassen, so daß aufgrund des Wachstums der festen Phase die geschmolzene Phase immer weiter nach oben wandert. Diese Verfahrensvariante setzt voraus, daß die Strahlungsquelle und die Chargiereinrichtung diese Wanderungsbewegung der Schmelze nachvollziehen und sich gleichfalls entsprechend dem wachsenden Kristall nach oben bewegen. Ein solches Verfahren ist jedoch apparativ aufwendig. Bevorzugt werden daher Verfahrensvarianten eingesetzt, bei denen Strahlungsquelle, Chargiereinrichtung und geschmolzene Phase in einer im wesentlichen festen Position verbleiben, während die feste Phase abgesenkt wird, und zwar mit einer Geschwindigkeit, die im wesentlichen der Geschwindigkeit des Aufwachsens des Siliciums entspricht. Diese Geschwindigkeit kann je nach der Art des angestrebten Produktes variiert werden; so können beispielsweise Blöcke aus multikristallinem Silicium, die als Grundmaterial für Solarzellen dienen, mit schnelleren Wachstumsgeschwindigkeiten hergestellt werden als monokristalline Stäbe für die Herstellung von Scheiben für die Fertigung von elektronischen Bauelementen. Typische Wachstums- und damit auch Absenkgeschwindigkeiten liegen für multikristallines Material im Bereich von 0.5 bis 5 mm/min, während für monokristallines Material üblicherweise Werte von 0.2 bis 3 mm/min erzielt werden können. Aus der dann im jeweils konkreten Fall eingestellten Absenkgeschwindigkeit und der daraus sich ergebenden, in fester Form aus der geschmolzenen Phase abgeführten Siliciummenge kann beispielsweise auch die erforderliche Granulatmenge ermittelt werden, die jeweils zuchargiert werden muß. Umgekehrt kann auch, wenn die zuchargierbare Granulatmenge den limitierenden Faktor darstellt, die Absenkgeschwindigkeit entsprechend angepaßt werden.

Absenkbare Unterlagen, die gegebenenfalls auch gedreht werden können und die die Halterung und gezielte Vertikalbewegung des wachsenden Siliciumstabes oder -blockes gestatten, sind bekannt und beispielsweise in der eingangs genannten Patentliteratur beschrieben. Geeignet sind beispielsweise mit einer Ziehwelle verbundene und gegebenenfalls kühlbare Platten, auf denen das vorgelegte und z.B. als Unterlage für die geschmolzene Phase dienende Silicium ruht, von dem der Wachstumsprozeß ausgeht. Auch Halterungen in der Art der vom tiegelfreien Zonenziehen her bekannten Stabhalte- und Stabstützvorrichtungen oder Aufnehmervorrichtungen, in denen ein kleiner Impfkristall in einer Halterung mit einer umgebenden Stützeinrichtung für den größeren Durchmesser aufweisenden wachsenden Kristall befestigt ist, können beispielsweise eingesetzt werden.

Das Verfahren wird im Regelfall in Rezipienten durchgeführt, die die Einstellung und Aufrechterhaltung einer geeigneten Arbeitsatmosphäre gestatten. Diese lassen sich in der von anderen Kristallzuchtverfahren her bekannten Weise nach Maßgabe der jeweils eingesetzten Energiequelle und/oder gewünschter Dotier- oder Reinigungswirkungen auswählen und einstellen. Dabei kann grundsätzlich in Druckbereichen vom Vakuum bis zum Ultrahochbereich bis in den Überdruckbereich gearbeitet werden.

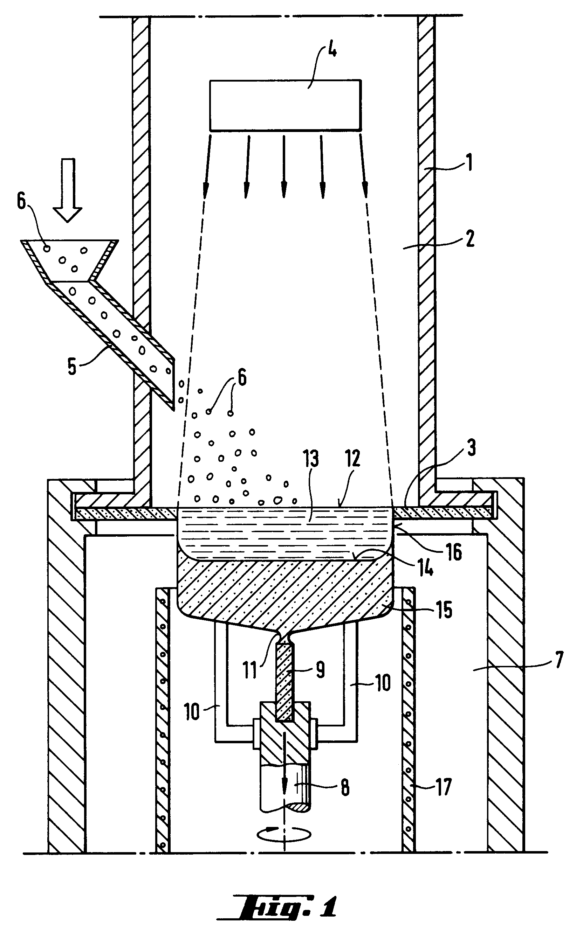

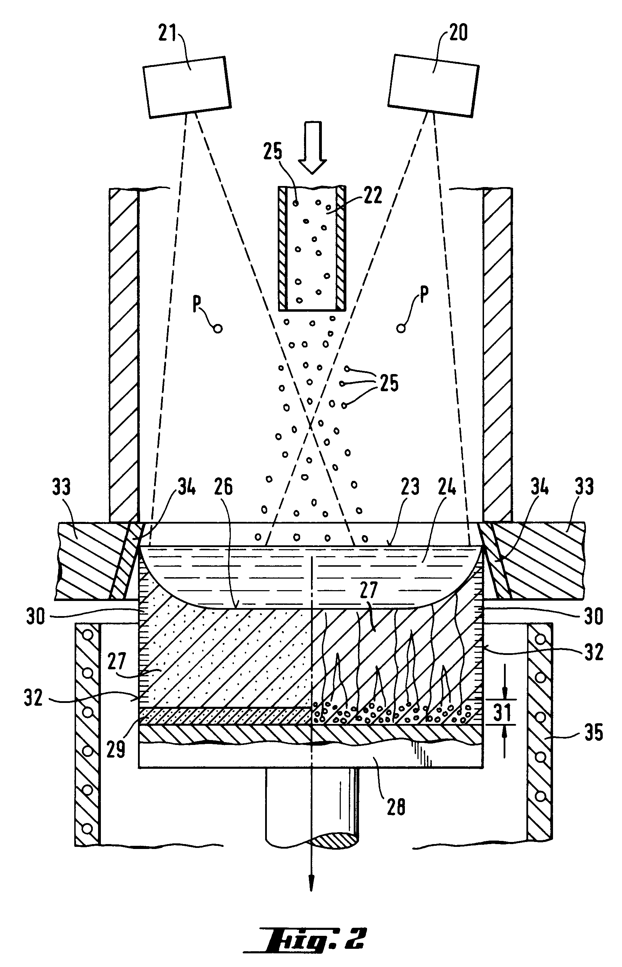

Das Verfahren sowie zu seiner Durchführung geeignete Vorrichtungen werden beispielhaft und schematisch an Hand der beiden Figuren erläutert. Fig. 1 zeigt dabei die Herstellung eines einkristallinen runden Stabes, Fig. 2 die Herstellung eines multikristallinen Blockes mit quadratischem Querschnitt.

Fig. 1 zeigt eine aus Gründen der Übersichtlichkeit nur schematisch angedeutete, von einer Abschirmung 1 aus inertem Material, vorzugsweise Silicium umgebene Chargier- und Schmelzkammer 2, die an ihrer Grundfläche von einer zu Beginn des Prozesses noch vollständig festen Dicht- und Stützplatte 3 aus Silicium abgeschlossen ist. In der Kammer befindet sich eine auf die Stützplatte 3 gerichtete Elektronenstrahlquelle 4. Außerdem mündet hier ein Chargierkanal 5, durch den von einem nicht dargestellten, außerhalb liegenden und gegebenenfalls temperierbaren Siliciumreservoir Granulat 6 auf die Grundfläche der Stützplatte chargiert werden kann.

Unterhalb der Dicht- und Stützplatte befindet sich die Kristallisationskammer 7, in welcher eine vertikal bewegliche und drehbare Kristallhalterung 8 vorgesehen ist, in der ein Impfkristall 9 befestigt ist und an der zweckmäßig zusätzliche Stützen 10 angebracht sind, die zur Aufnahme und Stabilisierung des entstehenden Kristallstabes dienen.

Zu Beginn des Kristallisationsvorganges wird der Impfkristall in seine Anfangsposition hochgefahren, die sich bevorzugt dicht unterhalb des Zentrums der noch vollständig geschlossenen, festen Dicht- und Stützplatte 3 befindet. Nun wird diese mit Hilfe der Elektronenstrahlquelle 4 von der Mitte her langsam aufgeschmolzen, bis eine zunächst nur kleine Schmelzlinse entstanden ist, mit welcher der Impfkristall von unten her in Kontakt gebracht werden kann. Nun kann in der z.B. vom Tiegelziehen her bekannten Weise zunächst zur Entfernung von Versetzungen eine Verengung 11 (der sog. "Dash-Hals") erzeugt werden, bis dann durch Vergrößerung der bestrahlten Fläche der Durchmesser der Schmelzlinse allmählich vergrößert wird, um schließlich den Nenndurchmesser des Kristalles zu erreichen. Bei diesem Vorgang wird vorteilhaft der Impfkristall gedreht und langsam abgesenkt, wobei es gleichzeitig erforderlich sein kann, zur Aufrechterhaltung des Schmelzniveaus bereits Granulat in die bestrahlte freie Oberfläche der geschmolzenen Phase zu chargieren.

An diese Anfahrphase schließt sich dann der eigentliche Ziehprozeß an. Dabei wird in die mit Hilfe der eingestrahlten Energie auf einer Temperatur von bis zu 200°C, vorteilhaft 50 bis 150°C oberhalb des Schmelzpunktes gehaltene freie Oberfläche 12 der geschmolzenen Phase 13 über den Chargierkanal 5 Granulat 6 kontinuierlich oder taktweise zugeführt. Gleichzeitig geht an der gegenüberliegenden Grenzfläche 14 zwischen der geschmolzenen Phase 13 und der festen Phase, dem Kristall 15, Material aus dem schmelzflüssigen in den festen Zustand über und wächst auf den Kristall 15 auf. Durch Absenken der zugleich rotierenden Kristallhalterung 8 in dem Maße, wie Material zuchargiert wird und auf den Kristall aufwächst, wird das Niveau der geschmolzenen Phase konstant auf der Höhe der Dicht- und Stützplatte 3 gehalten, während der wachsende Kristall nach unten aus der Schmelze abgezogen wird. Dabei ist auch zu beachten, daß die Länge des freien Seitenmeniskus 16 der geschmolzenen Phase 13, der sich zwischen der Stützplatte 3 und dem Kristall 15 ausbildet und beispielsweise die Drehung ermöglicht, den zulässigen Grenzwert nicht überschreitet, bei dem der Meniskus reißt und die Schmelze abläuft. Dieser Grenzwert beträgt z.B. bei Silicium erfahrungsgemäß etwa 8 mm.

In der Kristallisationskammer 7 kann eine zusätzliche Nachheizung 17 vorgesehen sein, um eine gezielte Abkühlung des Kristalles zu ermöglichen und das Auftreten von thermischen Spannungen zu vermeiden. Da bei der hier dargestellten Ausführungsform die Schmelzkammer 2 und die Kristallisationskammer 7 gegeneinander gasdicht gehalten werden können, lassen sich auch verschiedene Arbeitsdrücke einstellen. Während beispielsweise in der Schmelzkammer 2 schon wegen der Elektronenstrahlung ein möglichst gutes Vakuum von vorteilhaft 10⁻¹ bis 10⁻⁵ mbar eingestellt wird, kann der Druck in der Kristallisationskammer 7 demgegenüber auch auf deutlich höheren Werten von vorzugsweise 1 bis 50 mbar gehalten werden, beispielsweise wenn eine bestimmte Gase enthaltende Atmosphäre gewünscht wird. Dies kann beispielsweise der Fall sein, wenn über einen Strom von Spülgasen, z.B. Inertgasen wie etwa Argon die Diffusion von Verunreinigungen in den heißen Kristall verringert wird oder mittels beigefügter Dotiergase eine Dotierung über die geschmolzene Phase vorgenommen werden soll. Diese Druckdifferenz hat auch den Vorteil, daß der freie Seitenmeniskus 16 der geschmolzenen Phase gestützt und stabilisiert wird.

Bei Erreichen der vorgesehenen Kristallänge wird der Ziehvorgang bevorzugt dadurch beendet, daß die bestrahlte Fläche allmählich verkleinert wird, so daß der Kristalldurchmesser entsprechend abnimmt und schließlich der zur Spitze eingeschnürte Kristall aus der verbleibenden Schmelzlinse austaucht. Anschließend kann die restliche Schmelze z.B. durch weiteres Reduzieren der eingestrahlten Leistung zum vollständigen Erstarren gebracht werden. Damit sind Schmelz- und Kristallisationskammer wieder wie zu Beginn des Verfahrens von einer festen Dicht- und Stützplatte getrennt, so daß nach Entnahme des fertigen Kristalls, gegebenenfalls Austausch der Stützplatte und Bereitstellen eines Impfkristalls der nächste Ziehprozeß in analoger Weise eingeleitet werden kann.

In der Fig. 2 wird eine zur Herstellung von blockförmigen Kristallen geeignete Ausführungsform des Verfahrens sowie eine zu seiner Durchführung geeignete Vorrichtung schematisch dargestellt.

In einem aus Gründen der Übersichtlichkeit nicht dargestellten, zweckmäßig gasdichten oder evakuierbaren Rezipienten sind eine oder mehrere, beispielsweise zwei Elektronenstrahlheizquellen 20, 21 sowie ein Chargierkanal 22 vorgesehen, mit deren Hilfe die freie Oberfläche 23 einer geschmolzenen Phase 24 gleichmäßig beheizt und mit Granulat 25 beschickt werden kann. An der gegenüberliegenden Oberfläche geht die geschmolzene Phase über die Grenzfläche 26 in den Kristall 27 über, der auf einer absenkbaren, heiz-oder kühlbaren Halteplatte 28 aufliegt.

Beim Kristallisationsvorgang wird, analog der bei der Fig. 1 erläuterten Verfahrensweise, unter Energiezufuhr Granulat 25 auf die freie Oberfläche 23 der Schmelze chargiert, wo es aufschmilzt und damit gleichzeitig an der gegenüberliegenden Grenzfläche flüssig/fest den Kristall 27 zum Wachsen bringt. Entsprechend der Aufwachsgeschwindigkeit wird die Halteplatte 28 abgesenkt, so daß letztlich die geschmolzene Phase auf dem selben Niveau verbleibt, während nach unten der allmählich wachsende Kristall abgezogen wird.

Zur Einleitung des Kristallisationsvorganges wird in der ersten Phase die Halteplatte 28 nach oben in die Ausgangsstellung gefahren. Die Halteplatte kann dabei mit einer beispielsweise einkristallinen Impfkristallplatte 29 belegt sein (in der Fig. 2 in der linken Hälfte dargestellt), welche dann, gegebenenfalls bereits unter Zufuhr von Granulat, zur Erzeugung der geschmolzenen Phase angeschmolzen wird. Bei dieser Verfahrensvariante lassen sich bei der weiteren Kristallisation im wesentlichen einkristalline Blöcke herstellen, die lediglich in der Randzone 30 multikristalline Bereiche aufweisen. Werden grob kristalline Impfkristallplatten verwendet, so erhält man auch Blöcke mit multikristalliner, kolumnarer Struktur aus einkristallinen Bereichen mit kristallographischer Vorzugsorientierung.

Derartige Blöcke können gemäß einer anderen, einfacheren Verfahrensvariante auch dadurch hergestellt werden, daß in der Startphase auf die in Ausgangsstellung befindliche Halteplatte 28 Granulat chargiert wird, welches dann zunächst zu einer Zwischenschicht 31 gesintert wird, ehe nach Erreichen. einer ausreichenden Schichtdicke die Strahlungsleistung erhöht und eine die Sinterschicht überschichtende geschmolzene Phase erzeugt wird. Der eigentliche Kristallisationsprozeß erbringt dann das genannte multikristalline Material, das sich besonders gut zur Herstellung von Solarzellen eignet. Diese Variante ist in der rechten Hälfte der Fig. 2 dargestellt.

Die Querschnittsfläche des Kristalls 27, die vorzugsweise quadratisch, tetragonal oder hexagonal ist, und seine Seitenflächen 32 werden vorteilhaft durch gekühlte, bewegliche Segmente 33 vorgegeben, die in der jeweils gewünschten Form angeordnet sind. Die mit der Siliciumschmelze in Kontakt kommenden Oberflächen 34 dieser Segmente, welche sich günstig in Ziehrichtung erweitern, sind vorteilhaft aus Silicium gefertigt, um das Kontaminationsrisiko gering zu halten. Überraschend werden diese Oberflächen durch die geschmolzene Phase nicht benetzt, da bedingt durch die Energieeinstrahlung und den von den Segmenten ausgehenden Kühleffekt, Oberflächenströmungen das chargierte Granulat teilweise zum Rand der geschmolzenen Phase transportieren, wo es eine Sinterschicht zum kalten Segment ausbildet, die dessen direkten Kontakt mit der Schmelze verhindert.

Zweckmäßig wird auch eine Nachheizung 35, z.B. aus widerstandsbeheizten Platten, vorgesehen, die den Kristall nach seinem Austritt aus der eigentlichen Kristallisationszone umgibt und dazu dient, eine gleichmäßige und langsame Abkühlung und damit letztendlich einen spannungsarmen Endzustand des Produktes sicherzustellen. Der erhaltene Block kann, gegebenenfalls nach Abtrennen der gestörten Randbereiche, beispielsweise in Einzelblöcke zersägt werden, die ihrerseits dann z.B. mittels Draht- oder Gattersägen in Scheiben als Solarzellengrundmaterial zersägt werden können.

Das erfindungsgemäße Verfahren gestattet es, Kristalle aus sich beim Erstarren ausdehnenden Halbleitermaterialien wie Silicium oder Germanium sowohl mit runder als auch polygonaler, vorzugsweise quadratischer, tetragonaler oder hexagonaler Grundfläche herzustellen. Es eignet sich besonders gut für die Herstellung von Kristallen mit großer Grundfläche, d.h. bis zu etwa 200 mm Durchmesser oder Kantenlängen bis zu etwa 500 mm. Die Vorteile liegen vor allem darin, daß weder Schmelztiegel noch Kokillen erforderlich sind und damit ein kontaminationsfreies Kristallwachstum ermöglicht wird. Darüber hinaus erfolgt die Kristallisation mit einer weitgehend ebenen Kristallisationsfront, was beispielsweise eine besonders einheitliche Orientierung der einkristallinen Bereiche bei multikristallinem Material und eine homogene Dotierstoffverteilung bewirkt. Ferner tragen analog zur Zonenreinigung Segregationseffekte dazu bei, daß ein besonders reines Produkt erhalten wird. Insbesondere kann bei dem Verfahren die Kohlenstoffeinschleppung stark eingeschränkt werden, da auf die Verwendung von kohlenstoffhaltigen Werkstoffen oder Hilfsmitteln weitgehend verzichtet werden kann. Daneben lassen sich auch niedrige Sauerstoffgehalte erzielen, da keine Kontakte der geschmolzenen Phase mit Quarzgefäßwänden erforderlich sind und unter Sauerstoff abreichernden Druckbedingungen gearbeitet werden kann. Ein weiterer Vorteil besteht darin, daß als Ausgangsstoffe keine aufwendig abgeschiedenen Vorstäbe nötig sind, sondern leicht nachchargierbares Granulat eingesetzt werden kann, welches beispielsweise auch aus der Abscheidung im Fließbettreaktor stammen kann. Schließlich sind auch noch die erzielbaren hohen Kristallisationsraten, die spannungsarme Kristallabkühlung und die problemlose Prozeßsteuerung zu nennen, die über leicht beherrschbare Prozeßparameter erfolgt. Nicht zuletzt ist auf die günstige Energiebilanz des Verfahrens zu verweisen, die darauf beruht, daß während des gesamten Prozesses lediglich eine geringe Menge geschmolzenen Materials bereitgestellt werden muß, und die beim Erstarren gewonnene Kristallisationswärme zum Aufschmelzen des zuchargierten Granulates genutzt werden kann.

Nachstehend wird das Verfahren an Hand von Ausführungsbeispielen näher erläutert:

### Beispiel 1:

In einer der Fig. 1 entsprechenden Anordnung war in vertikaler Position eine Elektronenstrahlquelle in der Weise ausgerichtet, daß ein senkrechter Elektronenstrahl auf die Mitte der in etwa 100 cm Entfernung befindliche Dicht- und Stützplatte gerichtet werden konnte. Diese Stützplatte bestand aus einer Siliciumscheibe mit ca. 7.5 mm Dicke und bildete die untere Begrenzung der Schmelzkammer mit ca. 20 cm Durchmesser und die obere Begrenzung der Kristallisationskammer, deren Durchmesser etwa 30 cm betrug. Die Schmelzkammer war auf einen Druck von 10⁻⁶ mbar evakuiert, während in der Kristallisationskammer mit Hilfe eines konstanten Argonstromes ein Druck von etwa 1 mbar eingestellt war. Unterhalb des Zentrums war an die Stützplatte eine Kristallhalterung mit einem einkristallinen Impfkristall aus Silicium (Durchmesser ca. 3 mm, (100)-Orientierung) bis auf einen dünnen Spalt herangefahren.

Zunächst wurde mit der Einstrahlung von Energie begonnen und im Zentrum der Stützscheibe eine Schmelzlinse erzeugt, deren oberer Durchmesser etwa 12 mm, und deren unterer etwa 4 mm betrug. Nun konnte der Impfkristall angesetzt und in Drehung mit etwa 10 UPM versetzt werden. Unter allmählichem Absenken des Kristallhalters wurde nun die Schmelzlinse zunächst verengt, bis sich der sog. "Dash-Hals" ausgebildet hatte und versetzungsfreies Wachstum erreicht war. Danach wurde in der Phase des Konus-Ziehens unter sorgfältiger Überwachung und Anpassung der Absenkgeschwindigkeit des Kristallhalters der Schmelzlinsendurchmesser stetig vergrößert, bis der gewünschte Nenndurchmesser des zu ziehenden Kristalls von ca. 150 mm erreicht war. Der Ablauf dieser Phase kann dadurch erleichtert werden, daß eine Stützplatte vorgesehen wird, die einen verdickten Zentrumsbereich besitzt, an den sich ein dünnerer Übergangsbereich bis etwa zum gewünschten Nenndurchmesser des Kristalles anschließt, der von einem die ursprüngliche Dicke besitzenden Außenbereich umgeben ist. Um in der Endphase des Konusziehens die Tiefe der geschmolzenen Phase konstant zu halten, wurde über die Granulatzuführung bereits Siliciumgranulat (Korngröße 1-5 mm, spez. Widerstand ca. 1 Ωcm) in die freie Oberfläche der Schmelze zuchargiert.

Während der anschließenden Wachstumsphase wurde die freie Oberfläche durch Einstrahlung einer Leistung von ca. 40 W/cm² auf einer Temperatur von etwa 1540-1550°C gehalten. Die Höhe der geschmolzenen Phase betrug ca. 12 mm, der freie Seitenmeniskus hatte eine Länge von etwa 7 mm. Das Granulat der oben genannten Spezifikation wurde mit einer Rate von ca. 41g/min zuchargiert und ermöglichte ein Kristallwachstum und damit eine Abziehgeschwindigkeit von etwa 1 mm/min. Die Drehgeschwindigkeit des Kristallhalters betrug etwa 10 UPM. Zum Abbau thermischer Spannungen durchlief der Kristall nach der Kristallisation noch einen etwa 5 cm langen Nachheizbereich in Form eines auf etwa 1000°C gehaltenen Heizringes mit ca. 18 cm Durchmesser.

Bei Erreichen einer Länge von ca. 30 cm wurde die bestrahlte Fläche kontinuierlich verkleinert und die Granulatzufuhr gedrosselt, wodurch eine konusartige Abnahme des Kristalldurchmessers erreicht werden konnte, bis schließlich die Verbindung zwischen der Kristallspitze und der verbleibenden Schmelzlinse abriß. Die Energiezufuhr wurde nun gestoppt, die Stützplatte vollständig erstarren gelassen und schließlich der Kristall entnommen.

Der erhaltene Kristall war einkristallin und frei von Versetzungen. Das erhaltene Material war p-leitend, wobei die spez. Leitfähigkeit über die Kristallänge etwa 1 Ωcm betrug.

### Beispiel 2:

Eine der Fig. 2 entsprechend aufgebaute Anordnung war mit einer quadratischen Halteplatte mit ca. 300 mm Kantenlänge ausgerüstet, die aus Kupfer gefertigt war und in ihrem Inneren über ein mit Wasser beschicktes Kühlsystem verfügte. Anfänglich war die Halteplatte ganz nach oben gefahren und schloß dabei mit den nach außen geschrägten, mit Siliciumplatten belegten Innenwänden der ebenfalls wassergekühlten Segmente einen etwa 5 cm tiefen Hohlraum ein.

Nun wurde die Granulatzufuhr in Gang gesetzt und Granulat (Spezifikation wie in Beispiel 1) auf die Halteplatte chargiert. Nach Erreichen einer Schütthöhe von etwa 3 cm wurde die Energiezufuhr über die beiden Elektronenstrahlquellen aufgenommen (Leistung zunächst ca. 27 kW) und dadurch ein Zusammensintern des Granulates bewirkt. Nun wurde, bei fortgesetzter Granulatzufuhr, die eingestrahlte Leistung erhöht, bis das Granulat von oben her aufzuschmelzen begann. Gleichzeitig wurde die Halteplatte langsam abgesenkt, um die Schmelzenoberfläche auf konstanter Höhe zu halten. Schließlich hatte sich eine geschmolzene Phase ausgebildet, deren Tiefe in der Mitte ca. 50 mm betrug, während im Kontaktbereich zu den Segmentflächen sich Granulat angesammelt hatte und eine dünne Sinterschicht bildete, die die geschmolzene Phase nach außen abschirmte.

Nun begann die eigentliche Wachstumsphase, bei welcher unter konstanter Energieeinstrahlung in die freie Oberfläche der geschmolzenen Phase mit einer Rate von ca. 24g/min Granulat (vortemperiert auf ca. 120°C) zucargiert wurde. Daraus ergab sich eine Wachstumsgeschwindigkeit an der gegenüberliegenden Phasengrenze flüssig/fest von etwa 2mm/min, mit welcher auch die Halteplatte abgesenkt wurde. Das Kristallwachstum erfolgte multikristallin mit einer kolumnaren Struktur mit Kristallitgrößen bis zu etwa 5 mm.

Bei Erreichen einer Blockhöhe von etwa 40 cm wurde die Granulatzufuhr unterbrochen und unter allmählich verringerter Energieeinstrahlung der Block vollständig erstarren gelassen. Nach einer Abkühlphase von ca. 6 Stunden zum langsamen Abbau der vertikalen Temperaturdifferenz wurde der Block entnommen, auf Raumtemperatur abgekühlt und die gesintertes Granulat enthaltenden Randbereiche abgetrennt.

Die anschließende Untersuchung des Materials ergab für die Versetzungsdichte den ausgezeichneten Wert von 10³ bis 10⁵/cm². Die Kohlenstoffgehalte lagen mit ca. 10¹⁶ Atomen C/cm³ im Bereich des Ausgangsgranulates und zeigten, daß bei der Blockherstellung keine Kontamination eingetreten war. Die Sauerstoffgehalte waren gegenüber dem Ausgangswert deutlich verringert und lagen im Bereich von 5·10¹⁵ Atomen O/cm³. Daraus ergibt sich, daß das Verfahren hervorragend zur Herstellung von Siliciumblöcken als Ausgangsmaterial für Solarzellen geeignet ist.

## Patentansprüche

1. Verfahren zur Herstellung von Stäben oder Blöcken aus beim Erstarren sich ausdehnendem Halbleitermaterial durch Kristallisieren einer aus Granulat erzeugten Schmelze, dadurch gekennzeichnet, daß eine eine feste Phase des Halbleitermaterials überschichtende geschmolzene Phase des Halbleitermaterials mit einer dieser festen Phase gegenüberliegenden freien Oberfläche erzeugt wird, und daß beim Kristallisationsvorgang zur Aufrechterhaltung der geschmolzenen Phase in die freie Oberfläche Energie zugeführt und kontinuierlich oder taktweise Granulat chargiert wird, wodurch an der gegenüberliegenden Schmelzenoberfläche Halbleitermaterial zum Aufwachsen auf die feste Phase gebracht wird.

2. Verfahren nach Anspruch 1, dadurch gekennzeichnet, daß die Energiezufuhr durch Strahlung, insbesondere Elektronenstrahlung, vorgenommen wird.

3. Verfahren nach den Ansprüchen 1 oder 2, dadurch gekennzeichnet, daß als Halbleitermaterial Silicium eingesetzt wird.

4. Verfahren nach einem oder mehreren der Ansprüche 1 bis 3, dadurch gekennzeichnet, daß beim Kristallisationsvorgang die feste Phase gegebenenfalls unter Drehung bezüglich der geschmolzenen Phase mit einer Geschwindigkeit abgesenkt wird, die im wesentlichen der Geschwindigkeit des Aufwachsens des Halbleitermaterials entspricht.

5. Verfahren nach einem oder mehreren der Ansprüche 1 bis 4, dadurch gekennzeichnet, daß die freie Oberfläche der geschmolzenen Phase seitlich durch umgebendes festes Halbleitermaterial stabilisiert wird.

6. Verfahren nach einem oder mehreren der Ansprüche 1 bis 5, dadurch gekennzeichnet, daß die Höhe der geschmolzenen Phase und die Korngröße des chargierten Granulates so abgestimmt werden, daß diese Höhe mindestens dem Zweifachen der maximalen Eintauchtiefe der Granulatkörner in der geschmolzenen Phase entspricht.

7. Verfahren nach einem oder mehreren der Ansprüche 1 bis 6, dadurch gekennzeichnet, daß die Höhe der geschmolzenen Phase maximal 50 mm beträgt.

8. Verfahren nach einem oder mehreren der Ansprüche 1 bis 7, dadurch gekennzeichnet, daß Granulat mit mittleren Korngrößen von 0.1 bis 10 mm, vorzugsweise 1 bis 6 mm eingesetzt wird.

9. Verfahren nach einem oder mehreren der Ansprüche 1 bis 8, dadurch gekennzeichnet, daß die Temperaturdifferenz innerhalb der geschmolzenen Phase höchstens 200°C beträgt.

10. Vorrichtung zur Durchführung des Verfahrens nach einem oder mehreren der Ansprüche 1 bis 9, gekennzeichnet durch
a) mindestens eine die Erzeugung und Aufrechterhaltung einer eine feste Halbleiterphase überschichtenden geschmolzenen Halbleiterphase mit einer freien Oberfläche gestattende Energiequelle,
b) die freie Oberfläche der geschmolzenen Phase seitlich umgebende feste Teile aus Halbleitermaterial,
c) mindestens eine Zuführeinrichtung für Granulat in die freie Oberfläche der Schmelze, und
d) eine absenkbare und gegebenenfalls drehbare Halterung für die von dem geschmolzenen Halbleitermaterial überschichtete feste Phase.
